# EUROPEAN PATENT APPLICATION

(11) **EP 1 632 993 A1**
(43) Date of publication of application: **08.03.2006**
(21) Application number: 04734952.7
(22) Date of filing: 26.05.2004
(51) Int. Cl.: H01L 21/304

(54) **PRODUCTION METHOD FOR SEMICONDUCTOR WAFER**

(30) Priority: 27.05.2003 JP 2003149782
(71) Applicant: Sumco Corporation, Tokyo 105-8634 (JP)
(72) Inventor: Asakawa, K., c/o Sumco Corporation, Tokyo 105-8634 (JP)
(74) Representative: Lohr, Georg
(86) International application number: PCT/JP2004/007571
(87) International publication number: WO 2004/107428

(57) **Abstract**

A production method for a semiconductor wafer is provided in which semi-fixed abrasive grain grinding with free abrasive grains reduces minute surface undulations generated by wire saw slicing or double disc grinding as well as simplifying conventional semiconductor wafer fabrication process steps. A production method for a semiconductor wafer **characterized by** conducting a slicing process, then a beveling process, an etching process, and a one side or double side polishing process, wherein a semi-fixed abrasive grinding process using a porous polishing pad and free abrasive grains is conducted after the slicing process.

## Description

### Technical Field

The present invention relates to a method of obtaining from a single crystal ingot a semiconductor wafer with high flatness and low deformation under processing, more particularly to a production method for a semiconductor wafer with which semi-fixed abrasive grinding with free abrasive grains reduces minute surface undulations generated by wire saw slicing or double disc grinding while planarizing a semiconductor wafer as well as simplifying conventional semiconductor wafer fabrication process steps.

### Background Art

Generally, a production method for a semiconductor wafer adopts the following process steps:
1) A slicing process which slices a single crystal ingot taken from a single crystal growing apparatus to obtain thin disk-shaped wafers.
2) A beveling process which prevents wafers from chipping and cracking.
3) A lapping process which planarizes beveled wafers.
4) An etching process which removes a grinding damage layer occurred in wafer surfaces by the processing.
5) A beveling and polishing process which conducts final polishing on beveled portions.
6) A polishing process which polishes one side or both sides of the wafers.
7) A process which conducts final polishing on the wafers.

Then, for the purpose of improving flatness and reducing minute surface undulations in a typical production method for a semiconductor wafer like the above method, methods below and the like are proposed: a method where a slicing process, a beveling process, and a lapping process are conducted, and then reverse rotation surface grinding is done for both sides, and as required an etching process for removing residual strain is conducted for finishing by a double side polishing process, as shown in Fig. 6 (see JP-A-9-246216) ; and a method where after a slicing process, a double disc grinding process, a beveling process and a lapping process are conducted, reverse rotation surface grinding is done for both sides, and as required an etching process for removing residual strain is conducted for finishing by a one side or double side polishing process as shown in Fig. 7 (see paragraph [0002] JP-A-2002-124490).

However, a lapping apparatus for use in the lapping processes in the conventional production methods for a semiconductor wafer described above is increased in size with wafer size enlargement, and pressing problems arise such as increases in consumable materials cost and apparatus cost, operators' work load and apparatus size with increased wafer size, and an increase in industrial wastes (waste lapping powder) due to the increase in used materials. Furthermore, when single side grinding is conducted right after slicing, there is a problem that undulations generated by wire sawing cannot be removed. To solve this problem, a variety of methods are proposed that replace a lapping apparatus with a double disc grinding machine. However, they have the problem that minute surface undulations (level differences of a few tens µm, in cycles of a few mm) are generated on the surface of a wafer fabricated by the double disc grinding machine, the undulations are caused by double disc grinding. Thus, further, a method is proposed in which after double disc grinding, lapping is done using an elastic surface plate, simplifying fabrication steps in order to reduce minute surface undulations and obtain a more uniform surface (the invention described in JP-A-2002-124490). However, compared with a metal surface plate, abrasive grains work softly to obtain a wafer surface with less grinding damage, but the method has a problem that its stock removal rate is slow and the elastic surface plate wears down very quickly and then cannot achieve good wafer flatness.

The invention has been made to solve the prior art problems described above. An object is to provide a production method for a semiconductor wafer with which semi-fixed abrasive grinding with free abrasive grains reduces minute surface undulations generated by wire saw slicing or double disc grinding as well as simplifying the usual semiconductor wafer fabrication process steps.

### Disclosure of the Invention

A production method for a semiconductor wafer according to the invention is characterized by using a process method in which free abrasive grains are held in a porous polishing pad for grinding. Furthermore, it is a production method for a semiconductor wafer characterized by conducting the individual processes of slicing followed by beveling, etching, and one side or double side polishing, wherein a semi-fixed abrasive grinding process using a porous polishing pad and free abrasive grains is conducted after the slicing process. Moreover, it is characterized by conducting a double disc grinding process after the slicing process.

The semi-fixed abrasive grinding process using the porous polishing pad and the fluid mixed free abrasive grains in the invention places free abrasive grains of grain count in the range #400 to #1000 in the porous polyurethane pad at low concentrations, and then grinds the wafer with the semi-fixed abrasive grains held in pores on the polishing pad surface. According to this method, since a wafer is ground by scratching action by abrasive grains held in the pad surface in the semi-fixed state, minute undulations generated by the previous processes such as slicing can be reduced.

Typically, lapping is a process method designed based on the principles of brittle fracture, processing a wafer surface by supplying a slurry having an abrasive grain concentration of about 20wt% to a surface plate to tumble abrasive grains in a slurry layer between the wafer and the surface plate. On the other hand, in the semi-fixed abrasive grinding according to the invention, the concentration of the abrasive grains in a slurry is lowered to about one-tenth of the usual lapping slurry to make the slurry layer thin, and most of abrasive grains can be held in pores on a porous pad surface to generate scratching action of the abrasive grains.

Therefore, according to the method of the invention, an excellent finished surface with relatively less grinding damage can be obtained very efficiently, and minute surface undulations generated by the slicing process or the double disc grinding process can be removed. Furthermore, the concentration of the abrasive grains in the slurry is lowered to about one-tenth of the usual concentration. Thus, the amount of the abrasive grains used is small, and cost reduction can be achieved by the reduction in consumable materials. The concentration of the abrasive grains in the slurry is lowered so that the polishing pad does not wear out quickly, and precise wafer flatness can be maintained. Moreover, in the invention, the above semi-fixed abrasive grinding process is conducted after the slicing process, or after the slicing process and the double disc grinding process, and thus the usual lapping process and the reverse rotation surface grinding process can be omitted, simplifying the fabrication process.

In addition, the semi-fixed abrasive grinding process according to the invention can be implemented in a grinding unit by attaching a porous pad to an existing apparatus such as a batch type double side polisher which processes multiple wafers at one time or a lapping apparatus.

### Brief Description of the Drawing

Fig. 1 is a fabrication flow chart illustrating an embodiment of a production method for a semiconductor wafer according to the invention;
Fig. 2 is a fabrication flow chart illustrating another embodiment according to the invention;
Fig. 3 is a schematic diagram illustrating an exemplary double side polisher adopted in a semi-fixed abrasive grinding process according to the invention;
Fig. 4 is an enlarged cross-section of a portion of a pad of the double side polisher shown in Fig. 3 pressed against a wafer;
Fig. 5 is a diagram equivalent to Fig. 4, which illustrates abrasive grain slurry being supplied for grinding in the state shown in Fig. 4;
Fig. 6 is a fabrication flow chart illustrating one conventional production method for a semiconductor wafer; and
Fig. 7 is a fabrication flow chart illustrating one conventional production method for a semiconductor wafer.

### Best Mode for Carrying out the Invention

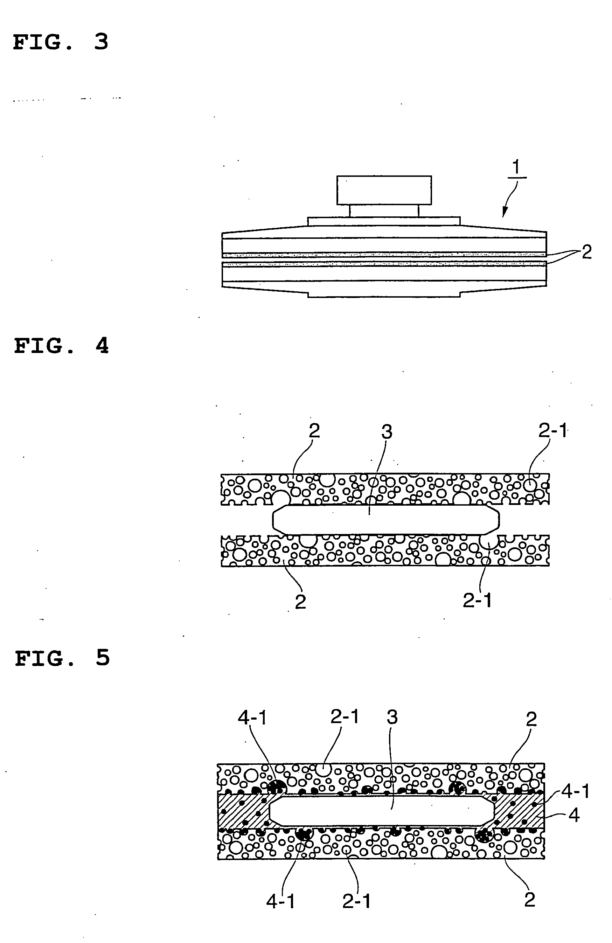

In Figs. 3 to 5 in the invention, 1 denotes a double side polisher, 2 denotes a porous pad, 2-1 denotes pores, 3 denotes a semiconductor wafer, 4 denotes slurry, and 4-1 denotes abrasive grains.

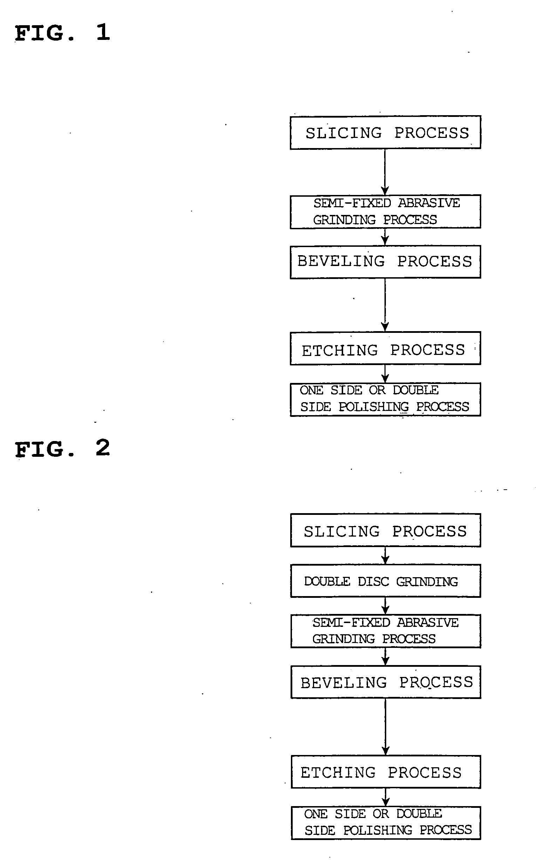

As shown in Fig. 1, a method according to the invention sequentially conducts the individual processes of slicing, semi-fixed abrasive grinding, beveling, etching, and one side or double side polishing. Furthermore, as shown in Fig. 2, it is a method that sequentially conducts individual processes of slicing, double disc grinding, semi-fixed abrasive grinding, beveling, etching, and one side or double side polishing.

The double side polisher 1 adopted in the semi-fixed abrasive grinding process according to the invention is a batch type polisher 1 which processes multiple wafers at one time as shown in Fig. 3 and has porous pads attached on both sides which sandwich a wafer. As shown in Fig. 4, a porous closed-cell polyurethane pad used in typical polishing can be used as the porous pad, for example. However, the pore 2-1 preferably has a diameter close to the abrasive grain diameter. For example, for abrasive grains having an average grain diameter of 20 µm, a pore diameter of 10 to 40 µm is suitable in consideration of processing efficiency. Moreover, a pad having a hardness of 90 (JIS-A) is effective for removing undulations on wafer surfaces. In addition, for the porous pad, the pore diameter, hardness, form and strength of pores (preferably, pores are separated) are selected considering the desired grain diameter, processing efficiency and wafer surface undulation removing effect of the abrasive grains. A pad fulfilling such conditions may be used, and is not necessarily limited to porous closed-cell polyurethane.

Furthermore, for the polishing machine, it is acceptable to use a lapping apparatus or a single wafer processing apparatus which processes wafers with a relatively small surface plate one by one, instead of the double side polisher. Moreover, it is acceptable to use an apparatus which processes one side or both sides of semiconductor wafers.

On the other hand, for the abrasive grains, free abrasive grains having grain count in the range from #400 to #1000 (the average grain diameter of 11 to 30 µm) are suitable. Furthermore, among the types of abrasive grains, lapping abrasive grains and the like such as GC and FO are relatively inexpensive and can be used for this process method. Moreover, for the concentration of the abrasive grains, although it is not limited particularly, low concentrations of 2wt% or below are preferable considering that the abrasive grains are held in the pores 2-1 on the porous pad surface.

In the polisher 1 shown in Fig. 3, when the slurry 4 in which a low concentration of free abrasive grains is suspended is supplied to the upper and lower porous pads 2 sandwiching and pressing against the semiconductor wafer 3 as shown in Fig. 5, abrasive grains 4-1 are held in the pores 2-1 on the pad surface to generate grinding action (scratching action of the abrasive grains) as semi-fixed abrasive grains with respect to the semiconductor wafer 3. When the slurry 4 is continuously supplied, the abrasive grains 4-1 in the slurry are held in the pad surface for a while and then drop. Thus, the reduction in processing efficiency due to the glazing of fixed abrasive grains does not occur as in the case of an abrasive grind wheel.

### Example

A slurry of GC #800 abrasive grains having a concentration of 0.3wt% was supplied to a double side polisher (Fig. 3) having a porous closed-cell polyurethane pad attached, and semi-fixed abrasive grinding was conducted. Consequently, in a 300 mm wafer, a semi-mirror surface semiconductor wafer was obtained with stock removal rate = 2 to 5 µm/min, flatness TTV < 1.0 µm, and the surface roughness Ra < 400 angstrom.

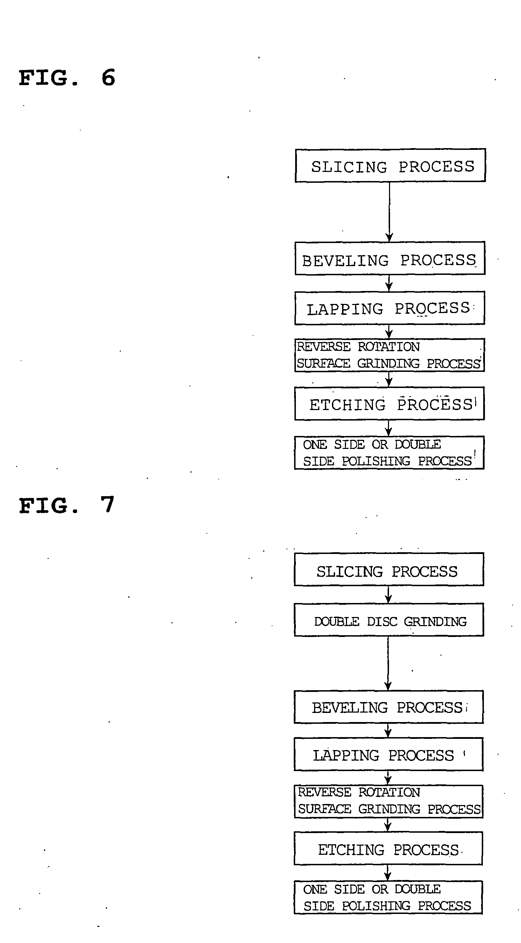

Furthermore, the process method (semi-fixed abrasive grinding) was incorporated appropriately in the fabrication process steps shown in Figs. 1 and 2 to fabricate semiconductor wafers. The results of reductions in thickness of the removed portion and minute surface undulations (nanotopography) compared to the conventional fabrication process shown in Fig. 7 are shown in Table 1.

As apparent from the results in Table 1, with respect to a nanotopography value of 24.9 nm in the 10 mm square size in the conventional process (Fig. 7), it was 24.7 nm in the fabrication process shown in Fig. 1, and it was 23.5 nm in the fabrication process shown in Fig. 2. Even though the thickness of the removed portion was reduced by 30 to 35 µm, the same quality of surface undulations as that of the conventional process could be obtained.

**Table 1**

| Types | Reduction of Thickness of Removed portion compared to conventional process (Fig. 7) | Nanotopography (10mm square) nm | |
|---|---|---|---|
| | | Ave. | Std. |
| The invention (Fig. 1) | -30 µm | 24.7 | 1.1 |
| The invention (Fig. 2) | -35 µm | 23.5 | 2.5 |
| Conventional process (Fig. 7) | | 24.9 | 1.9 |

As described above, according to the method of the invention, the surface undulations of the semiconductor wafer generated in the slicing process or the double disc grinding process can be removed by a semi-fixed abrasive grinding process similar to the lapping process and the like. Therefore, the conventional lapping process and the reverse rotation surface grinding process can be omitted, the semiconductor wafer fabrication process can be simplified, and process thickness of the removed portion can be decreased. Since slurry can be supplied at low concentrations, excellent effects can be exerted such as a reduction in consumable materials cost.

## Claims

1. A production method for a semiconductor wafer using a process method in which free abrasive grains are held in a porous polishing pad for grinding.

2. A production method for a semiconductor wafer which conducts individual processes of slicing and then beveling, etching, and one side or double side polishing,
wherein a semi-fixed abrasive grinding process using a porous polishing pad and free abrasive grains is conducted after the slicing process.

3. The production method for a semiconductor wafer according to claim 2, which conducts a double disc grinding process after the slicing process.
